# EUROPÄISCHE PATENTSCHRIFT

(11) **EP 4 490 793 B1**
(45) Veröffentlichungstag und Bekanntmachung des Hinweises auf die Patenterteilung: **27.05.2026**
(21) Anmeldenummer: 23706768.1
(22) Anmeldetag: 22.02.2023
(51) Int. Cl.: H01M 8/18, H01M 8/04537, G01R 31/389

(54) **VERFAHREN ZUR ÜBERWACHUNG EINES BATTERIEKRAFTWERKES**
METHOD FOR MONITORING AN ENERGY STORAGE POWER PLANT
PROCÉDÉ DE SURVEILLANCE D'UNE CENTRALE ÉLECTRIQUE À BATTERIE

(30) Priorität: 08.03.2022 DE 102022105462
(43) Veröffentlichungstag der Anmeldung: 15.01.2025
(73) Patentinhaber: Liva Power Management Systems GmbH, 65926 Frankfurt am Main (DE)
(72) Erfinder: LI, Yifeng, 89555 Steinheim (DE); LÜTH, Thomas, 79104 Freiburg (DE); KAUFMANN, Jens, 79102 Freiburg (DE)
(74) Vertreter: Fuchs Patentanwälte Partnerschaft mbB
(86) Internationale Anmeldenummer: PCT/EP2023/054417
(87) Internationale Veröffentlichungsnummer: WO 2023/169823

(56) Entgegenhaltungen:
- DE-A1- 102009 000 337
- TROVÒ ANDREA ET AL: "Multichannel Electrochemical Impedance Spectroscopy and equivalent circuit synthesis of a large-scale vanadium redox flow battery", JOURNAL OF POWER SOURCES, ELSEVIER, AMSTERDAM, NL, vol. 493, 3 March 2021 (2021-03-03), XP086530159, ISSN: 0378-7753, [retrieved on 20210303], DOI: 10.1016/J.JPOWSOUR.2021.229703
- TYLER JOSEPH PETEK: "Enhancing the Capacity of All-Iron Flow Batteries: Understanding Crossover and Slurry Electrodes", 1 May 2015 (2015-05-01), XP055365852, Retrieved from the Internet <URL:https://etd.ohiolink.edu/!etd.send_file?accession=case1428057617&disposition=inline> [retrieved on 20240112]

## Beschreibung

Die Erfindung betrifft ein Batteriekraftwerk mit einer Vielzahl von separaten Batterie-Energiespeichern bzw. Batteriemodulen, welche elektrisch miteinander verbunden sind, um elektrische Energie aufzunehmen oder abzugeben. Die Erfindung betrifft ein Batteriekraftwerk mit Batterie-Energiespeichern, welche als Redox-Flow-Batterie ausgeführt sind.

Solche Batteriekraftwerke mit einer Vielzahl von separaten Batterie-Energiespeichern, welche auch als Batteriemodule bezeichnet werden, sind aus dem Stand der Technik bekannt. So offenbart die WO 2014/170373 A2 beispielhaft ein Batteriekraftwerk mit mehreren parallelgeschalteten Batteriesträngen, wobei die Batteriestränge jeweils mehrere Gleichstrom-Batteriemodule umfassen, welche in Reihe geschaltet sind. Die Verschaltung der Batteriemodule in einem Batteriekraftwerk kann gemäß der Anwendung auf verschiedene Arten in Reihe und parallel erfolgen.

Ferner offenbart TROVÖ ANDREA ET AL: "Multichannel Electromechanical Impedance Spectroscopy and equivalent Circuit synthesis of a large-scale Vanadium redox flow battery" Verfahrensschritte zur Durchführung einer mehrkanaligen elektrochemischen Impedanzspektroskopie sowie einer Äquivalenzschaltungsauswertung eines Systems mit mehreren Vanadium-Redox-Durchflussbatterien.

Um einen langfristigen ungestörten Betrieb eines solchen Batteriekraftwerkes zu gewährleisten, ist es von Vorteil, wenn die einzelnen Batterie-Energiespeicher überwacht werden können, um eine Fehlfunktion oder ein Ausfallen der Batterie-Energiespeicher frühzeitig zu detektieren.

Die US 2018/0175429 A1 offenbart ein System und ein Verfahren, um Fehler in Redox-Flow-Batterien zu detektieren. Bei den zu detektierenden Fehlern handelt es sich um Lecks in den Elektrolyt-Tanks, wobei dieselben mit Hilfe von kapazitiv arbeitenden Sensoren detektiert werden.

Die KR 10-2019-0072790 A offenbart eine Vorrichtung und ein Verfahren, um die Lebensdauer einer Batterie zu ermitteln. Dabei kommt ein Impedanz-Messverfahren zum Einsatz, welches unter der Abkürzung EIS ("Electrochemical Impedance Spectroscopy") bekannt ist. Zur Ermittlung des Impedanz-Spektrums wird eine spezielle Vorrichtung an die elektrischen Anschlüsse der Batterie angeschlossen. Die Vorrichtung umfasst unter anderem einen Wellenformgenerator, einen Messkreis und einen Mikrocontroller.

Die Erfinder haben erkannt, dass das aus der KR 10-2019-0072790 A bekannte Verfahren im Prinzip dazu geeignet ist, den Zustand der Batterie-Energiespeicher vom Typ Redox-Flow eines Batteriekraftwerkes zu überwachen. Allerdings ergeben sich dabei folgende Schwierigkeiten. Der Anschluss der Messvorrichtung an die einzelnen Batterie-Energiespeicher ist sehr aufwändig, wenn man bedenkt, dass ein solches Batteriekraftwerk in der Regel sehr viele Batterie-Energiespeicher umfasst. Eine andere Möglichkeit bestünde darin, dass man jeden Batterie-Energiespeicher mit einer entsprechenden Messvorrichtung ausstattet, welche sozusagen einen integralen Bestandteil des jeweiligen Batterie-Energiespeichers bildet. Diese Lösung würde die Gestehungskosten des Batteriekraftwerkes nicht unerheblich in die Höhe treiben.

Die Aufgabe der Erfindung ist es, ein Verfahren zur Überwachung der Batterie-Energiespeicher eines Batteriekraftwerkes anzugeben, welches die genannten Nachteile wenigstens teilweise überwindet.

Die Aufgabe wird erfindungsgemäß durch eine Ausführung entsprechend dem unabhängigen Anspruch gelöst. Weitere vorteilhafte Ausführungsformen der vorliegenden Erfindung finden sich in den Unteransprüchen.

Im Folgenden wird die Erfindung anhand von Figuren erläutert. Die Figuren zeigen im Einzelnen:
- Fig.1: Batteriemodul vom Typ Redox-Flow
- Fig.2: Elektrische Struktur eines Batteriekraftwerkes
- Fig.3: Signalformen des Anregungsstroms
- Fig.4: Nyquist-Diagramm
- Fig.5: Ablaufdiagramm des erfindungsgemäßen Verfahrens

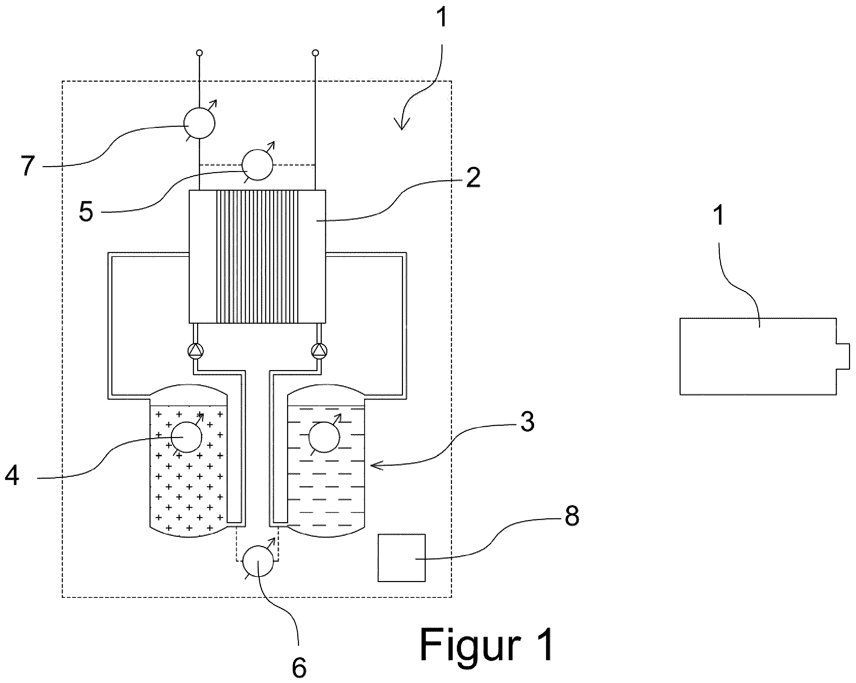

Figur 1 zeigt auf der linken Seite in schematischer Darstellung ein Batteriemodul vom Typ Redox-Flow. Das Batteriemodul ist mit 1 bezeichnet. Das Batteriemodul umfasst eine Zellanordnung, welche mit 2 bezeichnet ist, und eine Tankeinrichtung, welche mit 3 bezeichnet ist. Bei der Zellanordnung 2 handelt es sich um eine Anordnung von einer Vielzahl von Redox-Flow-Zellen, welche beliebig angeordnet sein können. Beispielsweise könnte es sich um einen einzelnen Zell-Stack (d.h. einer Serienschaltung von mehreren Redox-Flow-Zellen), eine Serienschaltung von mehreren Stacks, eine Parallelschaltung von mehreren Stacks, oder um eine Kombination von Serien- und Parallelschaltung von mehreren Stacks handeln. Die Tankeinrichtung 3 dient zum Speichern des Elektrolyten und zur Versorgung der Zellanordnung 2 mit Elektrolyt. Dazu umfasst die Tankeinrichtung 3 bis auf wenige Ausnahmen wenigstens zwei Tanks, ein Rohrsystem zur Verbindung der Tanks mit der Zellanordnung 2 und Pumpen zum Fördern des Elektrolyten. Figur 1 zeigt dabei zwei separate Pumpen. Genauso gut könnte der Elektrolyt mit einer Doppelkopfpumpe gefördert werden, d.h. mit zwei Pumpen, welche über einen gemeinsamen Motor angetrieben werden. Die Tankeinrichtung 3 ist dabei so ausgebildet, dass sie alle Zellen der Zellanordnung 2 mit Elektrolyt versorgen kann. Fördern die Pumpen also den Elektrolyten, so werden alle Zellen der Zellanordnung 2 von demselben durchströmt.

Das Batteriemodul 1 umfasst optional wenigstens einen Temperatursensor, welcher so angeordnet ist, dass er eine Elektrolyt-Temperatur erfassen kann. In Figur 1 sind zwei solche Sensoren dargestellt, von denen einer mit 4 bezeichnet ist. Die Temperatursensoren 4 sind in der Ausführungsform gemäß Figur 1 in der Tankeinrichtung 3 angeordnet. Sie könnten aber genauso gut an jeder anderen geeigneten Stelle im Batteriemodul 1 angeordnet sein, an der sie eine Elektrolyt-Temperatur erfassen können.

Das Batteriemodul 1 umfasst ferner wenigstens einen weiteren Sensor. Dieser Sensor ist so ausgebildet, dass er die sogenannte Leerlaufspannung (Open Circuit Voltage - OCV) messen kann. Der OCV-Wert ist ein Maß für den Ladezustand des Batteriemoduls (State of Charge - SoC). Der Sensor zur Messung der Leerlaufspannung ist mit 6 bezeichnet. Ein weiterer optionaler Sensor ist so ausgebildet, dass er die Klemmenspannung der Zellanordnung 2 und damit auch des Batteriemoduls 1 messen kann. Beim Laden bzw. Entladen des Batteriemoduls 1 unterscheidet sich die Klemmenspannung von der Leerlaufspannung um die Spannung, die über dem Innenwiderstand der Zellanordnung 2 abfällt. Der Sensor zur Messung der Klemmenspannung ist mit 5 bezeichnet. Ein weiterer optionaler Sensor ist so ausgebildet, dass er den Strom durch das Batteriemodul 1 messen kann. Der Sensor zur Messung des Stroms durch das Batteriemodul 1 ist mit 7 bezeichnet. Optional umfasst das Batteriemodul 1 ferner eine Auswerteeinrichtung, welche mit 8 bezeichnet ist.

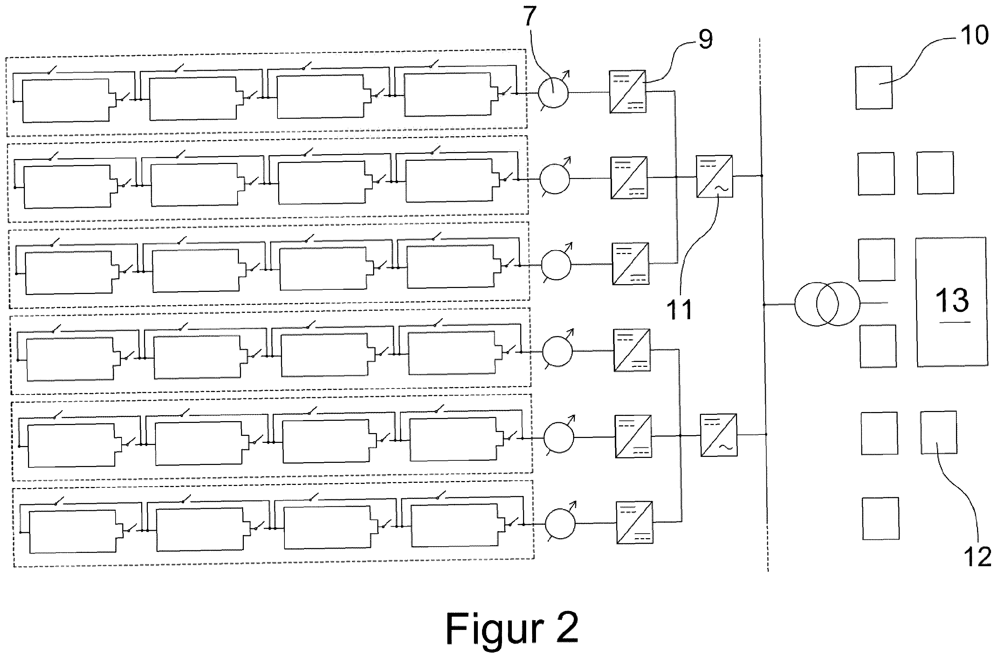

Figur 2 zeigt eine mögliche Realisierungsform der elektrischen Struktur eines Batteriekraftwerkes in stark vereinfachter Darstellungsweise. Auf der linken Seite sind Batteriestränge mit einer Reihenschaltung von Batteriemodulen angedeutet. Ein Batteriestrang kann ein einzelnes Batteriemodul oder mehrere in Reihe geschaltete Batteriemodule umfassen. Je ein Batteriestrang ist von einem gestrichelten Rechteck umgeben. Jedes Batteriemodul eines Batteriestranges kann optional mit Hilfe von einem Schalterpaar in den Batteriestrang hinein oder herausgeschaltet werden. Jeder Batteriestrang ist mit einem DC-DC Steller verbunden. Einer der DC-DC Steller ist dabei mit 9 bezeichnet. Jeder der Batteriestränge umfasst optional einen Sensor zum Messen des Stromes, welcher durch den Batteriestrang fließt. Einer dieser Sensoren ist mit 7 bezeichnet. Da der Strom, welcher durch den Batteriestrang fließt, auch durch jedes Batteriemodul desselben Batteriestranges fließen muss, kann der Strom sowohl, wie in Figur 2 dargestellt, mit einem Sensor 7 außerhalb der Batteriemodule 1 gemessen werden, oder, wie in Figur 1 dargestellt, mit Sensoren 7 innerhalb der Batteriemodule 1 gemessen werden. Mehrere Batteriestränge sind jeweils über Gleichstromschienen miteinander verbunden und bilden so jeweils eine Batteriestranggruppe. Dabei sind die DC-DC Steller jeweils zwischen der zugehörigen Gleichstromschiene und den Batteriesträngen angeordnet. Jede Batteriestranggruppe ist über einen DC-AC Umrichter mit den Wechselstromschienen des Batteriekraftwerkes verbunden. Einer der DC-AC Umrichter ist mit 11 bezeichnet. In Figur 2 bilden jeweils drei Batteriestränge eine Batteriestranggruppe. Die Anzahl der Batteriestränge pro Batteriestranggruppe kann jedoch beliebig sein und hängt nur von der Leistungsfähigkeit der verwendeten DC-AC Umrichter und der Nennleistung der Batteriestränge ab. Die Wechselstromschienen sind über einen Transformator an das Übertragungsnetz angebunden. Falls eine Batteriestranggruppe nur einen Strang umfasst, dann kann der betreffende DC-DC-Steller 9 auch entfallen.

Die DC-DC Steller 9 und die DC-AC Umrichter 11 dienen dazu, in die mit denselben verbunden Batteriemodule 1 einen Strom einzuspeisen, um die Batteriemodule 1 zu laden oder zu entladen.

Die rechte Seite von Figur 2 zeigt beispielhaft eine für ein solches Batteriekraftwerk geeignete Steuerungsstruktur. Jeder Batteriestrang hat eine eigene Steuerung, von denen eine mit 10 bezeichnet ist. Jede Batteriestranggruppe hat wiederum eine eigene Steuerung, von denen eine mit 12 bezeichnet ist. Die zum Batteriekraftwerk gehörige Zentralsteuerung ist mit 13 bezeichnet. Dabei können die untergeordneten Steuerungen 10 und 12 separat ausgeführt oder in die zur Zentralsteuerung gehörige Steuereinrichtung integriert sein. Genauso gut könnten die untergeordneten Steuerungen 10 und 12 integral und die Zentralsteuerung 13 separat ausgeführt sein. Falls eine Batteriestranggruppe nur einen Strang umfasst, dann benötigt diese Batteriestranggruppe nur eine Steuerung, d.h. dann kann eine der zugehörigen Steuerungen 10 oder 12 entfallen.

Die Erfinder haben erkannt, dass mit Hilfe der in den vorangehenden Abschnitten beschriebenen Elemente eines Batteriekraftwerkes eine rudimentäre Zustandsüberwachung mittels eines Impedanz-Messverfahrens realisiert werden kann. D.h. der Zustand der Batteriemodule kann überwacht werden, ohne dass eine spezielle Vorrichtung an die Batteriemodule angeschlossen werden muss.

Wenn diese rudimentäre Zustandsüberwachung eine Auffälligkeit eines oder mehrerer Batteriemodule eines Batteriestranges detektiert, kann entweder eine Wartung der betreffenden Batteriemodule oder eine eingehendere Untersuchung des Zustandes derselben durchgeführt werden.

Zur Beschreibung des erfindungsgemäßen Verfahrens werden an dieser Stelle zunächst die grundlegenden Schritte erläutert, die üblicherweise zur Ermittlung von Impedanz-Spektren durchgeführt werden. Bei der Impedanz-Spektroskopie wird die elektrische Anordnung als ein System betrachtet, dessen Charakteristik bestimmt werden soll. Dies erfolgt durch die Anregung mit einem definierten Eingangssignal, während das Ausgangssignal als Systemantwort gemessen wird. Dies kann durch das Einspeisen eines Stroms I erfolgen, während gleichzeitig die über der elektrischen Anordnung abfallende Spannung V gemessen wird. Dabei dient der eingespeiste Strom I als Anregung des elektrischen Systems. Die Spannung V stellt das Antwortsignal des elektrischen Systems dar. Umgekehrt kann das System auch durch das Anlegen einer Spannung V angeregt werden, während der Strom I als Systemantwort gemessen wird. Im Folgenden wird das Verfahren anhand der ersteren Variante beispielhaft beschrieben, wobei die Zusammenhänge ebenso für die zweite Variante gelten. Grundlegend für die Spektroskopie ist dabei, dass das System mit Signalen unterschiedlicher Frequenzen angeregt wird, welche ebenso wie das zugehörige Antwortsignal zeitaufgelöst erfasst werden. Aus Anregungs- und Ausgangssignalen können im Folgenden durch mathematische Methoden die Impedanzen des Systems bei den Frequenzen, die bei der Anregung verwendet wurden, berechnet werden.

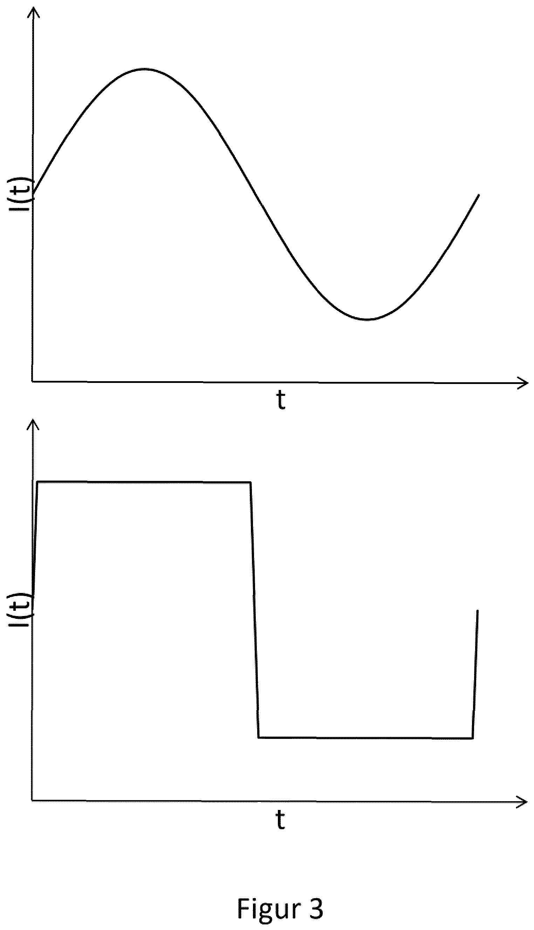

Bei der Impedanz-Spektroskopie gibt es generell mehrere Möglichkeiten für Signalformen, mit denen das System angeregt werden kann. Üblicherweise kommen sinusförmige Signale zum Einsatz, wie im oberen Teil von Figur 3 gezeigt ist. Bei der Anregung des Systems mit solch einem Signal kann die Impedanz bei genau der Frequenz des Sinussignals berechnet werden. Dabei wird das Signal üblicherweise über mehrere Periodendauern eingespeist. Um Impedanzen bei weiteren Frequenzen und damit ein Impedanz-Spektrum zu bestimmen, müssen in der Folge ebenso Messungen bei diesen Frequenzen einzeln nacheinander durchgeführt werden. Eine alternative Möglichkeit besteht darin, Signale einzuspeisen, die Anteile mehrerer Frequenzen enthalten. Dafür bietet sich beispielsweise eine Signalform an, die einer sogenannten Rechteckfunktion folgt, wie im unteren Teil von Figur 3 abgebildet ist. Im Gegensatz zum Sinussignal enthält ein Rechtecksignal zusätzlich zur Grundfrequenz weitere Frequenzanteile bei den ungeradzahligen Harmonischen der Grundfrequenz. Wird ein System nun mit einem Rechtecksignal angeregt, so enthalten sowohl Anregungs- als auch Antwortsignal Signalanteile bei mehreren Frequenzen. Somit kann nicht nur der zur Grundfrequenz der Rechteckfunktion gehörige Impedanz-Wert bestimmt werden, sondern noch weitere Impedanz-Werte, die zu den Frequenzen gehören, die den höheren Ordnungen der Grundfrequenz entsprechen. In der Praxis wird die Anzahl der zu erfassenden höheren Ordnungen durch die endliche Flankensteilheit der Rechtfunktion des Anregungsstroms, durch die endliche Abtastrate von Strom und Spannung sowie von überlagerten Störsignalen begrenzt.

Im Prinzip kann sogar ein beliebig zeitlich variierendes Anregungssignal verwendet werden, d.h. auch ein Signal, das nicht periodisch ist. Gemäß der Fourier Theorie kann ein solches Signal als Überlagerung von periodischen Funktionen betrachtet werden. Die Grundfrequenz ergibt sich dabei zu 1/T (bzw. 2π/T), wobei T die zeitliche Länge des Signals ist. In der Praxis werden jedoch meist die in Figur 3 gezeigten Signalformen verwendet. Auch die Anregung mit einzelnen rechteckigen Pulsen oder Sprungfunktionen ist praktikabel. Bei periodischen Signalen ist die Grundfrequenz selbstverständlich durch 1/T₀ (bzw. 2π/ T₀) gegeben, wobei T₀ die Periodendauer ist.

Das Ergebnis der Impedanz-Spektroskopie ist die Impedanz Z der elektrischen Anordnung als Funktion der Frequenz f bzw. der Kreisfrequenz ω=2πf: Z(w). Dabei ist Z(w) eine Funktion im Raum der imaginären Zahlen und enthält Informationen über Betrag und Phase der Impedanzen. Bei frequenzreiner Anregung mit einem Sinussignal ergibt sich ω direkt aus der Frequenz des Anregungsstromes. Der Betrag der Impedanz bei dieser Frequenz berechnet sich aus dem Quotienten der Beträge des sinusförmigen Spannungssignals und Stromsignals, während sich die Phase aus der Differenz der Phasen beider Signale berechnet. Bei einem Anregungsstrom, welcher neben der Grundfrequenz noch höhere Frequenzen umfasst, werden sowohl der erfasste Anregungsstrom I als auch das erfasste Antwortsignal V einer Fouriertransformation unterworfen, und man erhält F{I}(w) und F{V}(w). Die gesuchte Impedanzfunktion Z(w) ergibt sich dann zu Z(ω)= F{V}(ω)/F{I}(ω). Dabei ist klar, dass Z(w) nur für solche Frequenzen ω definiert ist, für die F{I}(ω) nicht null ist. Ferner ist zu erwähnen, dass für die Impedanz-Spektroskopie von Batterien das zeitaufgelöste Antwortsignal der Klemmenspannung noch um die Leerlaufspannung korrigiert werden muss, sodass sich der Spannungsabfall über dem Innenwiderstand der Batterie ergibt, d.h. V = Vₖₗₑₘₘ - V_{OCV}.

Die Darstellung von Z(w) kann vorteilhaft in Form eines sogenannten Nyquist-Diagramms erfolgen. Dabei wird in x-Richtung der Realteil von Z(w) und in y-Richtung der negative Imaginärteil von Z(w) aufgetragen. Die Einheit von Z(w) ist Ohm.

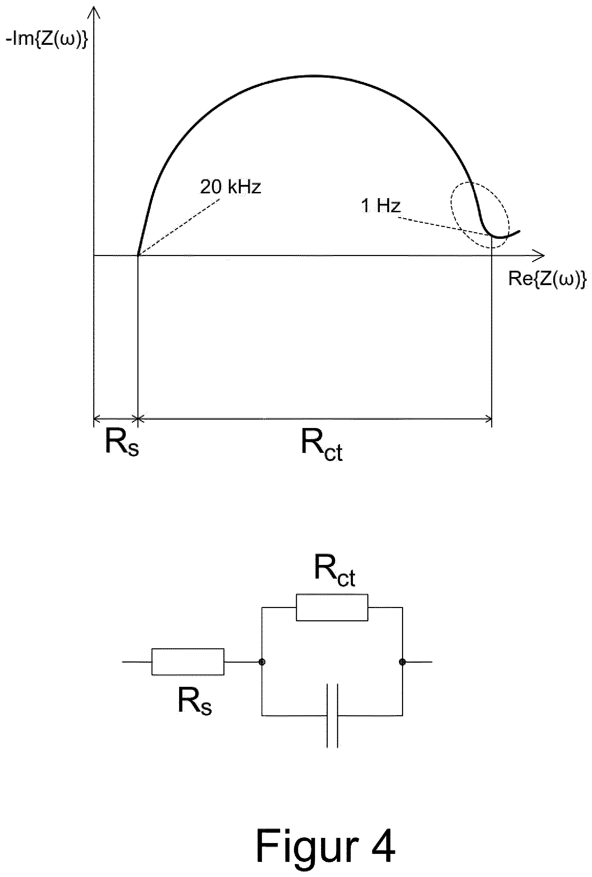

Figur 4 zeigt im oberen Teil ein typisches Nyquist-Diagramm einer Redox-Flow-Batterie in qualitativer Form. Im unteren Teil von Figur 4 ist ein vereinfachtes Ersatzschaltbild dargestellt, welches für die Interpretation des oben dargestellten Nyquist-Dagramms verwendet wird. Aus dem Diagramm können zwei Widerstandswerte abgeleitet werden: Rₛ und R_{ct}. Rₛ wird als statischer Innenwiderstandsanteil gedeutet, welcher z.B. durch den Widerstand der Kontakte und der Zuleitungen gegeben ist, während R_{ct} den Anteil beschreibt, welcher sich aus der Kinetik des Ladungstransfers zwischen Elektrode zu Elektrolyt ergibt. Aus dem Ersatzschaltbild wird klar, dass Rₛ unabhängig von der Frequenz zum Gesamtwiderstand beiträgt, während der Beitrag von R_{ct} bei hohen Frequenzen durch die parallel liegende Doppelschichtkapazität verringert wird und daher nur bei kleinen Frequenzen nennenswert beiträgt. Üblicherweise ist Rₛ bei Frequenzen von ungefähr 20 kHz im Nyquist-Diagramm grob ablesbar, während Rₛ+R_{ct} bei Frequenzen um 1 Hz abgetragen werden kann. Durch den parasitären Einfluss einer seriellen Induktivität (nicht abgebildet im Diagramm), bspw. durch die Zuleitungen, wird das Nyquist-Diagramm in Richtung der positiven imaginären Achse (also nach unten) verschoben. Dadurch ändert sich auch der Schnittpunkt mit der x-Achse. Rₛ kann somit grafisch nur ungefähr bestimmt werden. Genauere Ergebnisse können durch den mathematischen Fit eines Ersatzschaltbild-Modells erzielt werden. Im Folgenden wird die Summe Rₛ+R_{ct} als "Gesamtinnenwiderstand" bezeichnet, auch wenn dies nicht exakt dem Gleichstromwiderstand entspricht.

Die Erfinder haben erkannt, dass in einem Batteriekraftwerk mit Hilfe der DC-DC Steller 9 oder mit Hilfe der DA-AC Umrichter 11 ein zeitlich variabler Anregungsstrom I erzeugt werden kann, mit dem die zugehörigen Batteriemodule für eine rudimentäre Impedanzspektroskopie angeregt werden können. Durch die Leistungselektronik sind die Anstiegszeiten des Anregungsstroms begrenzt, womit sich nur Signale bis zu einer bestimmten oberen Frequenzgrenze mit einer vertretbaren Qualität erzeugen lassen. Bei der Verwendung eines Anregungssignals mit verschiedenen Frequenzanteilen wie dem Rechtecksignal ist ebenso die Anzahl der berechenbaren Frequenzanteile oberhalb der Grundfrequenz durch die Signalqualität und die Genauigkeit der Messeinrichtung begrenzt. Auch wenn somit kein Impedanzspektrum hoher Qualität bis hin zu hohen Frequenzen im kHz-Bereich erzielt werden kann, so sind dennoch Informationen über das Verhalten bei niedriger Frequenz in ausreichender Qualität vorhanden. Dies reicht aus, um die Summe Rₛ+R_{ct} zu bestimmen. Da Degradationsprozesse von Redox-Flow-Batterien oft zu erhöhten Kontaktwiderständen oder zu verschlechterten Ladungstransferprozessen führen, stellt sich dann ein erhöhter Wert der Summe Rₛ+R_{ct} ein, welcher mit dem erfindungsgemäßen Verfahren bestimmt werden kann. Daher ist das erfindungsgemäße Verfahren dazu geeignet, Batteriemodule zu identifizieren, die unter den genannten Problemen leiden. An den so identifizierten Batteriemodulen können dann weitere aufwändigere Untersuchungen durchgeführt werden, um die Probleme zu beheben.

Die Erfinder haben erkannt, dass es im Grunde schon ausreicht, wenn man einen einzigen Z(w)-Wert im Frequenzbereich ≤ 20 Hz bestimmt, um eine erste Indikation über mögliche Probleme der untersuchten Batteriemodule zu bekommen. Wenn sich der Gesamtinnenwiderstand eines Batteriemoduls erhöht, dann verschiebt sich nämlich die gesamte mit der gestrichelten Ellipse markierte Flanke des Nyquist-Graphen zu höheren Abszissen-Werten (Re{Z(w)}), so dass sich bei einer beliebigen Frequenz in diesem Bereich ebenfalls erhöhte Abszissen-Werte detektieren lassen.

Selbstverständlich können auch mehrere Z(w)-Werte bei verschiedenen niedrigen Frequenzen (≤ 20 Hz) bestimmt werden, um die Aussagekraft der Messung zu erhöhen. In diesem Fall können die bestimmten Impedanzen auch vor dem Vergleich mit dem unten beschriebenen vordefinierten Grenzwert mit einem geeigneten Modell gefittet werden, um die Aussagekraft der Messung noch weiter zu erhöhen.

Wie bereits oben erwähnt, wird im Folgenden und in den Ansprüchen das erfindungsgemäße Verfahren für den Fall beschrieben, dass als Anregung ein Stromsignal verwendet wird. Das ist jedoch nicht als einschränkend zu betrachten und umfasst auch den Fall, dass als Anregung ein Spannungssignal verwendet wird.

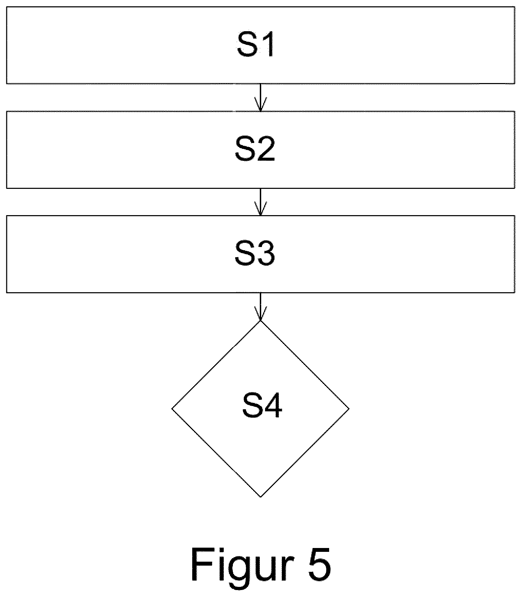

Die Schritte des erfindungsgemäßen Verfahrens sind in Figur 5 dargestellt. Das Verfahren umfasst wenigstens folgende Schritte:
S1: Erzeugung eines zeitlich variierendes Stromes I mit einer Grundfrequenz ω, mit welchem wenigstens ein Batteriemodul 1 zur Durchführung einer Impedanzspektroskopie angeregt wird;
S2: Zeitaufgelöste Erfassung des Anregungsstroms I und einer Antwortspannung V;
S3: Berechnung der Impedanz Z(w);
S4: Einleitung von Wartungsarbeiten an dem wenigstens einem Batteriemodul 1, wenn Re{Z(w)} einen vordefinierten Grenzwert überschreitet.

Dabei wird in Schritt S1 der Strom I mit Hilfe von einem DC-DC Stellers 9 oder, wenn die zugehörige Batteriestranggruppe nur einen Batteriestrang umfasst, mit Hilfe von einem AC-DC Umrichter 11 erzeugt, wobei die Grundfrequenz des erzeugten zeitlich variierenden Stromes f=ω/2π ≤ 20 Hz ist.

Der vordefinierte Grenzwert wird dabei so festgelegt, dass Re{Z(w)} für f=ω/2π ≤ 20 Hz von einem beliebigen "gesunden" Batteriemodul des Batteriekraftwerkes unterhalb des Grenzwertes zu liegen kommt. Dazu kann beispielsweise eine Stichprobe von "gesunden" Batteriemodulen mit Hilfe von Impedanzspektroskopie vermessen werden. Der Grenzwert wird dann so gewählt, dass alle Re{Z(w)} für f=ω/2π ≤ 20 Hz der vermessenen Batteriemodule deutlich (d.h. in Bezug auf die Messgenauigkeit und die Streuung der Re{Z(w)} der vermessenen Batteriemodule) unterhalb des Grenzwertes zu liegen kommen.

Im Folgenden wird unter dem Begriff "Umrichter" sowohl ein DC-DC Steller 9 als auch ein AC-DC Umrichter 11 verstanden. Ein solcher Umrichter nähert auf der DC-Seite einen zeitlich variablen Stromverlauf mit Hilfe von diskreten Stufen an. Daher wird auch ein sinusförmiger Stromverlauf gemäß dem oberen Teil von Figur 3 nicht eine einzige Frequenz darstellen. Es empfiehlt sich daher in jedem Fall auf die in Schritt S2 erfassten Signale eine Fouriertransformation anzuwenden, auch wenn ein Sinussignal verwendet wird.

Wenn die Leerlaufspannung des Batteriemoduls während der Ausführung des erfindungsgemäßen Verfahrens konstant bleibt oder als konstant angenommen werden kann, dann muss dieselbe bei der Ausführung des erfindungsgemäßen Verfahrens nicht erfasst werden, weil dieselbe nur den Gleichstrom-Anteil der Impedanz verändert und somit nicht zu Re{Z(w)} für ω ≠ 0 beiträgt. Falls sich die Leerlaufspannung jedoch während der Ausführung des erfindungsgemäßen Verfahrens zeitlich ändert, so sollte dieselbe in Schritt S2 zeitlich aufgelöst erfasst und wie oben beschrieben in Schritt S3 bei der Berechnung von Z(w) verwendet werden (d.h. V = Vₖₗₑₘₘ - Vocv).

Da die Innenwiderstände des wenigstens einen untersuchten Batteriemoduls von der Temperatur des Elektrolyten und der Durchflussrate des Elektrolyten durch die Zellanordnung abhängen, ist es von Vorteil diese Größen während der Durchführung des erfindungsgemäßen Verfahrens mitzuerfassen, und dieselben in Schritt S4 mit einzubeziehen. Von besonderem Vorteil ist es, wenn auch der Ladezustand (SoC) miterfasst und in Schritt S4 einbezogen wird. Dies kann beispielsweise dadurch geschehen, dass anstelle eines einzelnen Grenzwertes für den Realteil der Impedanz eine Funktion von Grenzwerten vordefiniert wird, wobei diese Funktion von Temperatur, Durchflussrate und SoC abhängt. Genauso gut können diese Größen dazu verwendet werden, um den bestimmten Gesamtinnenwiderstand (Re{Z(w)}) rechnerisch zu korrigieren und die Einleitung von Wartungsarbeiten vom so korrigierten Gesamtinnenwiderstand abhängig zu machen.

Als Maß für die Durchflussrate des Elektrolyten durch die Zellanordnung kann auch die Drehzahl bzw. die Leistungsaufnahme der Pumpen verwendet werden.

Mit dem erfindungsgemäßen Verfahren können alle Batteriemodule eines Batteriestrangs auf einmal überwacht werden, da der vom Umrichter erzeugte Anregungsstrom durch alle Module des Batteriestrangs fließt. Zur Erfassung und Auswertung des Anregungsstroms und der Antwortspannung gibt es verschiedene Möglichkeiten. Eine erste Möglichkeit besteht darin, dass die genannten beiden Größen auf Strangebene erfasst werden. Dazu werden der in Figur 2 dargestellte Stromsensor 7 und ein nicht dargestellter Spannungssensor verwendet. In der Regel umfassen in Frage kommende Umrichter einen geeigneten Spannungssensor, welcher in den Umrichter integriert ist. Für die Auswertung bzw. Berechnung der Impedanz Z(w) kommen die Steuerungen 10 und 12 in Frage. Damit kann dann die Impedanz des gesamten Batteriestranges bestimmt werden.

Eine zweite Möglichkeit besteht darin, dass die genannten beiden Größen auf Batteriemodulebene erfasst werden. Dazu werden die in Figur 1 dargestellten Sensoren 5 und 7 verwendet. Für die Auswertung bzw. Berechnung der Impedanz Z(ω) kann dann beispielsweise die Auswerteeinrichtung 8 verwendet werden.

Eine weitere Möglichkeit besteht darin, dass der Anregungsstrom auf Strangebene, d.h. mit dem Sensor 7 aus Figur 2, und die Antwortspannung der Batteriemodule auf Modulebene mit dem Sensor 5 aus Figur 1 erfasst werden. In diesem Fall muss für eine Synchronisation der so erfassten Messsignale gesorgt werden. Für die Auswertung bzw. Berechnung der Impedanz Z(w) kommen die Steuerungen 10 und 12 oder die Auswerteeinrichtung 8 in Frage.

Mit den zwei letztgenannten Methoden können die Impedanzen einzelner Batteriemodule ermittelt werden.

Die Leerlaufspannung wird, falls sie erfasst werden soll, auf Batteriemodulebene mit dem Sensor 6 erfasst. Eine Synchronisation der erfassten Leerlaufspannung mit den anderen Signalen ist nur dann notwendig, wenn die Leerlaufspannung zeitlich aufgelöst erfasst werden soll. Andernfalls wird sie üblicherweise lediglich zur Bestimmung des SoC verwendet.

Wenn der überwachte Batteriestrang die in Figur 2 dargestellten Schalterpaare umfasst, so kann auch eine beliebige Untermenge der zum Batteriestrang gehörigen Batteriemodule mit dem Umrichter verbunden und mit dem erfindungsgemäßen Verfahren überwacht werden.

Die mit dem erfindungsgemäßen Verfahren gewonnen Daten können in der Zentralsteuerung des Batteriekraftwerkes gespeichert und verwaltet werden.

Als Wartungsarbeiten in Schritt S4 kommen mehrere Möglichkeiten in Frage. Beispielsweise könnte das oder die betreffenden Batteriemodule mit Hilfe einer geeigneten Vorrichtung einer vollständigen Impedanz-Spektroskopie unterzogen werden, um die mit dem erfindungsgemäßen Verfahren gewonnen Daten zu verifizieren und weitere Informationen zu gewinnen, z.B. die separaten Werte von Rₛ und R_{ct}. Damit könnten der Zustand und ein potenzielles Problem des Batteriemoduls genauer diagnostiziert werden. Ferner käme in Frage, in den betreffenden Batteriemodulen die Zellanordnungen derselben zu tauschen, und die ausgebauten Zellanordnungen dann weiter zu untersuchen und ggf. zu reparieren oder zu entsorgen.

Das erfindungsgemäße Verfahren ermöglicht eine Überwachung der Batteriemodule mit Hilfe der Komponenten (Umrichter 9 bzw. 11, Sensoren 5, 6, 7), welche ohnehin in einem üblichen Batteriekraftwerk vorhanden sind. Daher erfordert das erfindungsgemäße Verfahren keine oder nur wenig zusätzliche Hardware.

### Bezugszeichenliste

- 1: Batteriemodul
- 2: Zellanordnung
- 3: Tankeinrichtung
- 4: Temperatursensor
- 5: Sensor zur Messung der Klemmenspannung
- 6: Sensor zur Messung der Leerlaufspannung
- 7: Sensor zur Messung des Stroms durch einen Batteriestrang
- 8: Auswerteeinrichtung
- 9: DC-DC Steller
- 10: Steuerung eines Batteriestranges
- 11: DC-AC Umrichter
- 12: Steuerung einer Batteriestranggruppe
- 13: Zentralsteuerung des Batteriekraftwerkes

## Patentansprüche

1. Verfahren zur Überwachung eines Batteriekraftwerkes umfassend eine Vielzahl von Batteriemodulen (1), welche als Redox-Flow-Batterie ausgeführt sind und jeweils eine Zellanordnung (2), eine Tankeinrichtung (3) zum Speichern eines Elektrolyten und Pumpen zum Fördern des Elektrolyten umfasst, und wobei jeweils ein oder mehrere in einer Reihenschaltung elektrisch miteinander verbundene Batteriemodule (1) einen Batteriestrang bilden, und wobei das Batteriekraftwerk einen Umrichter (9, 11) umfasst und eine DC-Seite des Umrichters (9, 11) so mit dem Batteriestrang verbunden ist, dass der Umrichter (9, 11) einen Strom in den Batteriestrang einspeisen kann, um die zugehörigen Batteriemodule (1) zu laden oder zu entladen, und wobei das Verfahren die folgenden Schritte umfasst:
S1: Erzeugung eines zeitlich variierenden Anregungsstromes I mit einer Grundfrequenz f, mit welchem wenigstens ein Batteriemodul (1) zur Durchführung einer Impedanzspektroskopie angeregt wird;
S2: Zeitaufgelöste Erfassung des Anregungsstrom I und einer Antwortspannung V;
S3: Berechnung der Impedanz Z(ω), wobei ω=2πf;
**dadurch gekennzeichnet, dass** das Verfahren den folgenden Schritt umfasst:
S4: Einleitung von Wartungsarbeiten an dem wenigstens einen Batteriemodul (1), wenn Re{Z(w)} einen vordefinierten Grenzwert überschreitet;
und wobei in Schritt S1 der Anregungsstrom I mit Hilfe des Umrichters (9, 11) erzeugt wird, wobei die Grundfrequenz des erzeugten zeitlich variierenden Anregungsstromes f ≤ 20 Hz ist.

2. Verfahren nach Anspruch 1, wobei während der Durchführung des Verfahrens in dem wenigstens einen Batteriemodul (1) eine Temperatur des Elektrolyten und eine Durchflussrate des Elektrolyten durch die Zellanordnung (2) erfasst wird, und wobei die Temperatur und die Durchflussrate im Schritt S4 mit einbezogen wird.

3. Verfahren nach Anspruch 1 oder 2, wobei während der Durchführung des Verfahrens in dem wenigstens einen Batteriemodul (1) ein Ladezustand erfasst wird, und wobei der Ladezustand im Schritt S4 mit einbezogen wird

4. Verfahren nach einem der Ansprüche 1 bis 3, wobei in Schritt S1 alle Batteriemodule (1) des Batteriestranges mit dem Anregungsstrom I zur Durchführung einer Impedanzspektroskopie angeregt werden.

5. Verfahren nach einem der vorherigen Ansprüche, wobei das wenigstens eine Batteriemodul (1) eine Auswerteeinrichtung (8), einen Sensor (5) zur Messung der Klemmenspannung Vₖₗₑₘₘ, einen Sensor zur Messung der Leerlaufspannung Vocv und einen Sensor (7) zur Messung des Anregungsstromes I durch das wenigstens eine Batteriemodul (1) umfasst, und wobei V = Vₖₗₑₘₘ - Vocv, und wobei der Schritt S3 von der Auswerteeinrichtung (8) ausgeführt wird.

## Claims

1. Method for monitoring a battery power plant comprising a plurality of battery modules (1) which are designed as a redox flow battery and each comprise a cell arrangement (2), a tank device (3) for storing an electrolyte and pumps for supplying the electrolyte, and wherein one or more battery modules (1) electrically connected to one another in a series connection form a battery string, and wherein the battery power plant comprises a converter (9, 11) and a DC side of the converter (9, 11) is connected to the battery string such that the converter (9, 11) can feed a current into the battery string in order to charge or discharge the associated battery modules (1), and wherein the method comprises the following steps:
S1: generating a time-varying excitation current I with a base frequency f, by which at least one battery module (1) is excited to perform an impedance spectroscopy;
S2: time-resolved detecting the excitation current I and a response voltage V;
S3: calculating the impedance Z(w), wherein ω = 2πf;
**characterized in that** the method comprises the following step:
S4: initiating maintenance work on the at least one battery module (1) if Re{Z(w)} exceeds a predefined limit value,
and wherein in step S1 the excitation current I is generated by use of the converter (9, 11), wherein the base frequency of the generated time-varying excitation current is f ≤ 20 Hz.

2. Method according to claim 1, wherein a temperature of the electrolyte and a flow rate of the electrolyte through the cell arrangement (2) are detected during the execution of the method in the at least one battery module (1), and wherein the temperature and the flow rate are included in step S4.

3. Method according to claim 1 or 2, wherein a state of charge is detected in the at least one battery module (1) during the execution of the method, and wherein the state of charge is included in step S4.

4. Method according to any one of claims 1 to 3, wherein in step S1 all battery modules (1) of the battery string are excited with the excitation current I to perform an impedance spectroscopy.

5. Method according to any one of the preceding claims, wherein the at least one battery module (1) comprises an evaluation device (8), a sensor (5) for measuring the terminal voltage V_{Klemm}, a sensor for measuring the open-circuit voltage V_{OCV} and a sensor (7) for measuring the excitation current I flowing through the at least one battery module (1), and wherein V = V_{Klemm} - V_{OCV}, and wherein step S3 is carried out by the evaluation device (8).

## Revendications

1. Procédé de surveillance d'une centrale à batterie comprenant une pluralité de modules de batterie (1) qui sont conçus comme des batteries à flux redox et comprennent chacun un agencement de cellules (2), un dispositif de réservoir (3) pour stocker un électrolyte et des pompes pour faire circuler l'électrolyte, et dans lequel un ou plusieurs modules de batterie (1) connectés électriquement en série les uns aux autres forment une chaîne de batteries, et dans lequel la centrale électrique à batterie comprend un convertisseur (9, 11) et un côté continu du convertisseur (9, 11) est connecté à la chaîne de batteries de telle sorte que le convertisseur (9, 11) peut alimenter un courant dans la chaîne de batteries afin de charger ou de décharger les modules de batterie (1) associés, et le procédé comprenant les étapes suivantes :
S1 : la génération d'un courant d'excitation I variant dans le temps avec une fréquence fondamentale f, avec lequel au moins un module de batterie (1) est excité pour réaliser une spectroscopie d'impédance ;
S2 : l'enregistrement temporellement résolu du courant d'excitation I et d'une tension de réponse V ;
S3 : le calcul de l'impédance Z(ω), où ω = 2πf ; le procédé étant **caractérisé en ce que** le procédé comprend l'étape suivante :
S4 : le déclenchement d'opérations de maintenance sur ledit au moins un module de batterie (1) lorsque Re{Z(ω)} dépasse une valeur limite prédéfinie ;
et dans lequel, à l'étape S1, le courant d'excitation I est généré à l'aide du convertisseur (9, 11), dans lequel la fréquence fondamentale du courant d'excitation généré variant dans le temps est f ≤ 20 Hz.

2. Procédé selon la revendication 1, dans lequel, pendant la mise en œuvre du procédé, une température de l'électrolyte et un débit de l'électrolyte à travers l'agencement de cellules (2) sont mesurés dans ledit au moins un module de batterie (1), et dans lequel la température et le débit sont pris en compte à l'étape S4.

3. Procédé selon la revendication 1 ou 2, dans lequel, pendant la mise en œuvre du procédé, un état de charge est détecté dans au moins un module de batterie (1), et dans lequel l'état de charge est pris en compte à l'étape S4.

4. Procédé selon l'une des revendications 1 à 3, dans lequel, à l'étape S1, tous les modules de batterie (1) de la chaîne de batteries sont excités avec le courant d'excitation I afin de réaliser une spectroscopie d'impédance.

5. Procédé selon l'une des revendications précédentes, dans lequel le au moins un module de batterie (1) comprend un dispositif d'évaluation (8), un capteur (5) pour mesurer une tension aux bornes Vₖₗₑₘₘ, un capteur pour mesurer une tension en circuit ouvert V_{ocv} et un capteur (7) pour mesurer le courant d'excitation I à travers au moins un module de batterie (1), et dans lequel V = Vₖₗₑₘₘ - V_{ocv}, et dans lequel l'étape S3 est exécutée par le dispositif d'évaluation (8).
